# EUROPÄISCHE PATENTSCHRIFT

(11) **EP 2 278 595 B1**
(45) Veröffentlichungstag und Bekanntmachung des Hinweises auf die Patenterteilung: **01.02.2012**
(21) Anmeldenummer: 10169801.7
(22) Anmeldetag: 16.07.2010
(51) Int. Cl.: H01B 12/10, H01L 39/14, H01L 39/24

(54) **NbTi-Supraleiter mit CuMn-Cu-Matrix**
NbTi superconductor with CuMn-Cu matrix
Supraconducteur NbTi doté d'une matrice CuMn-Cu

(30) Priorität: 20.07.2009 DE 102009027838
(43) Veröffentlichungstag der Anmeldung: 26.01.2011
(73) Patentinhaber: Bruker EAS GmbH, 63450 Hanau (DE)
(72) Erfinder: Thöner, Manfred, 63599 Biebergemünd (DE)
(74) Vertreter: Schmitt, Martin

(56) Entgegenhaltungen:
- WO-A1-2008/072852
- WO-A2-2007/136406
- GB-A- 2 038 532
- JP-A- 2010 097 902
- US-B1- 6 510 604
- WILSON: "Advances in low-loss Nb-Ti strand cable" PROCEEDINGS / WAMSDO WORKSHOP, [Online] 19. Mai 2008 (2008-05-19), - 23. Mai 2008 (2008-05-23) Seiten 8-12, XP009139537 ISBN: 978-92-9083-325-3 Gefunden im Internet: URL:http://cdsweb.cern.ch/record/1163708/f iles/p8.pdf ORD - 2009-00-00>

## Beschreibung

Die Erfindung betrifft einen Vorleiter zum Aufbau eines Supraleiter-Drahtes, umfassend
- eine Vielzahl von Sechskantelementen, und
- ein Hüllrohr, in welchem die Sechskantelemente angeordnet sind,
   wobei ein Teil der Sechskantelemente als CuMn-Kernleiterelemente ausgebildet sind, jeweils mit
- einem NbTi-Filament,
- einer Nb-Barriere und
- einer CuMn-Umhüllung,
   wobei diese CuMn-Kernleiterelemente kein elementares Kupfer enthalten.

Ein solcher Vorleiter ist bekannt geworden aus Martin N. Wilson, "Advances in low-loss Nb-Ti strand cable", WAMSDO Proceedings, Workshop on Accelerator Magnet Superconductors, Design and Optimization, CERN, Genf, Schweiz, 19.-23. Mai 2008, Seiten 8-12. GB 2 038 532 beschreibt, wie Nb₃Su-Stäbe mit Cu-Stäben zusammen gesetzt werden.

Supraleitermaterialien werden zur möglichst verlustfreien Leitung von elektrischen Strömen eingesetzt, insbesondere in Magnetspulen zur Erzeugung großer Magnetfeldstärken. Supraleitermaterialien müssen auf kryogene Temperaturen gekühlt werden, um den supraleitenden Zustand zu erreichen. Das derzeit am häufigsten eingesetzte Supraleitermaterial ist NbTi, welches zur Klasse der metallischen Tieftemperatursupraleiter gehört. NbTi ist vergleichsweise einfach herzustellen und zu handhaben.

Supraleiterdrähte aus NbTi werden unter anderem im so genannten Double-Stack-Verfahren hergestellt. Zunächst wird ein Kernleiterelement (auch Monofilament genannt) hergestellt, indem ein NbTi-Stab in eine rohrförmige Umhüllung, typischerweise aus Cu, eingefügt wird. Der NbTi-Stab ist noch mit einer äußeren Nb-Diffusionsbarriere versehen, um der Entstehung von intermetallischen Phasen aus Cu und Ti bei Wärmebehandlungen entgegenzuwirken. Nach einem Pressen/Ziehen und Sechskantverformung werden mehrere Kernleiterelemente in einem Hüllrohr, typischerweise aus Cu, zu einem Vorleiter gebündelt. Nach Pressen/Ziehen und Sechskantverformung werden wiederum mehrere Vorleiter in einem Mantelrohr gebündelt und erneut einem Pressen/Ziehen zu einem Supraleiterdraht unterzogen. Der fertige Supraleiterdraht enthält in der Regel mehrere Tausend NbTi-Filamente, die den elektrischen Strom in Parallelschaltung tragen.

In bestimmten Anwendungsbereichen ist es erforderlich, die Supraleiterdrähte in sich zeitlich schnell ändernden Magnetfeldern einzusetzen, insbesondere wobei aus Supraleiterdraht gewickelte Magnetspulen mit Wechselstrom oder gepulstem Strom betrieben werden. Dies führt grundsätzlich zu so genannten Wechselstromverlusten, vgl. dazu O. Henkel und E.M. Sawitzkij (Hrsg.), "Supraleitende Werkstoffe", VEB Deutscher Verlag für Grundstoffindustrie, Leipzig, 1. Auflage, 1982, Seiten 303-304. Die Wechselfeldverluste machen sich insbesondere in Wirbelfeldverlusten, Hystereseverlusten und Eigenfeldverlusten bemerkbar.

Durch Designmaßnahmen ist es möglich, die Wechselfeldverluste in Supraleiterdrähten zu begrenzen. Zur Verringerung der Hystereseverluste sollte ein geringer Filamentdurchmesser im µm-Bereich gewählt werden. Wirbelstromverluste lassen sich durch Verdrillen des Supraleiterdrahtes bei einer kurzen Verdrilllänge (twist pitch) begrenzen. Zur Vermeidung von Nahbereichkopplung (proximity coupling) und Zwischen-Filament-Kopplung (interfilamentary coupling) zwischen den NbTi-Filamenten ist es auch bekannt, als Matrixmaterial für die NbTi-Filamente eine Legierung aus Kupfer mit ca. 0,5 Gewichts% Mangan einzusetzen. Die geringere elektrische Leitfähigkeit der CuMn-Legierung im Vergleich zu elementarem Kupfer und die magnetischen Eigenschaften des Mangan in der CuMn-Legierung erschweren das Tunneln von Cooper-Paaren zwischen benachbarten Filamenten quer zur Längsachse des Supraleiterdrahtes.

Bei Änderungen des Magnetfelds verschieben sich die Flussschläuche innerhalb des Supraleiterdrahtes. Dabei fließen kurzzeitig resistive Ströme quer zu den supraleitenden Filamenten durch die normalleitende Matrix, wodurch sich der Supraleiterdraht erwärmt. Das Drahtdesign sollte im Supraleiterdraht eine ausreichende lokale Wärmekapazität vorsehen (dynamische Stabilisierung) und/oder eine ausreichend schnelle Wärmeabführung an das Kühlmittel, typischerweise flüssiges Helium, bereitstellen (kryogene Stabilisierung), so dass die freiwerdende Wärmemenge den Supraleiterdraht nicht über die Sprungtemperatur erwärmt. Kryogene und dynamische Stabilisierung erfolgen über einen im Supraleiterdraht angeordneten guten Normalleiter, insbesondere elementares Kupfer. Ein im Supraleiterdraht parallel zu den NbTi-Filamenten angeordneter guter Normalleiter ist auch zum Schutz eines Magneten im Falle eines plötzlichen Zusammenbruchs der Supraleitung (Quench) erwünscht.

Während es also aus Gründen der Begrenzung der Wechselstromverluste günstig ist, in der Umgebung der NbTi-Filamente schlecht leitendes Material wie eine CuMn-Legierung anzuordnen, ist es aus Gründen der Stabilisierung und des Magnetschutzes im Quenchfall günstig, dort gut leitendes Material wie elementares Kupfer anzuordnen.

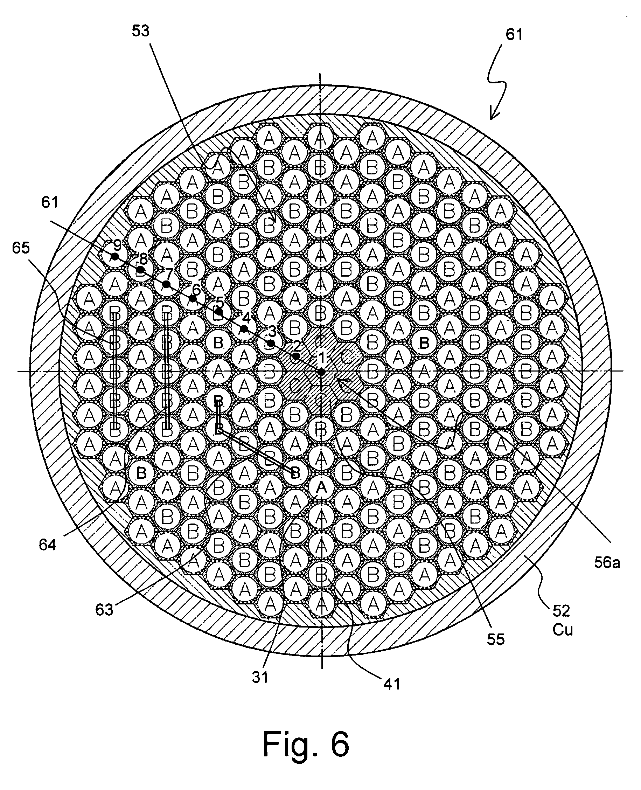

In Wilson, aaO, dortige Fig. 6, wird ein Drahtdesign mit gebündelten Kernleiterelementen, jeweils mit einem NbTi-Filament und einer CuMn-Umhüllung vorgestellt. Die Bündel von Kernleiterelementen sind von einer Kupfer-Matrix umgeben, die von CuNi-Barrieren durchzogen ist. Die CuNi-Barrieren verlaufen insbesondere zwischen den Bündeln. Dieses Drahtdesign ist sehr schwer zu fertigen.

Die DE 22 18 222 A beschreibt einen Supraleiterdraht, umfassend eine Vielzahl von hexagonalen Vorleitern. Jeder Vorleiter enthält eine Mehrzahl von Supraleiterunterfasern, welche jeweils von feinen Kupferdrähten umgeben sind und zusammen mit diesen eine hexagonale Struktur bilden. Die Kupferdrähte, welche zu benachbarten supraleitenden Unterfasern in der hexagonalen Struktur gehören, grenzen aneinander an.

### Aufgabe der Erfindung

Der Erfindung liegt die Aufgabe zugrunde, bei NbTi-Mulitfilamentdrähten auf einfache Weise eine gute Stabilisierung bei geringen Wechselstromverlusten zu gewährleisten.

### Kurze Beschreibung der Erfindung

Diese Aufgabe wird gelöst durch einen Vorleiter der eingangs genanten Art, der dadurch gekennzeichnet ist, dass eine Mehrzahl von Cu-Strukturen zwischen den CuMn-Kernleiterelementen verteilt angeordnet ist, wobei die Cu-Strukturen im Querschnitt des Vorleiters nicht aneinander angrenzen,
und dass jede Cu-Struktur aus einem Cu-Sechskantelement, das ist ein Sechskantelement enthaltend elementares Kupfer, oder mehreren zueinander benachbarten Cu-Sechskantelementen aufgebaut ist.

Die Erfindung schlägt vor, im Vorleiter verschiedene Typen von Sechskantelementen im Hüllrohr miteinander zu vermischen. Ein Teil (typischerweise 75% oder mehr) der Sechskantelemente ist als CuMn-Kernleiterelemente aufgebaut. Deren CuMn-Umhüllung begrenzt effektiv Verlustströme quer zur Filamenterstreckung, und Kopplungen der Filamente dieser Elemente untereinander bleiben gering. Zwischen verschiedenen NbTi-Filamenten wird im Rahmen der Erfindung bevorzugt ein Strompfad (quer zur Längsrichtung) nur durch mindestens eine Schicht aus CuMn zugelassen.

Um gleichzeitig eine ausreichende Stabilisierung, insbesondere dynamische Stabilisierung, sicherzustellen, sind zwischen die CuMn-Kernleiterelemente auch Cu-Strukturen gemischt. Diese Cu-Strukturen bestehen aus einem oder mehreren Cu-Sechskantelementen, die elementares ("hochreines") Kupfer als einen sehr guten Normalleiter enthalten (typischwerweise in ihrem Außenbereich, etwa in der Umhüllung im Falle eines Cu-Kernleiterelements) und so Strom- und Wärmeleitungspfade parallel (in Richtung der Längsachse des Vorleiters) zu den CuMn-Kernleiterelementen zur Verfügung stellen. Die Cu-Sechskantelemente besitzen im Querschnitt näherungsweise die gleiche Größe wie die CuMn-Kernleiterelemente. Die Cu-Strukturen grenzen nicht aneinander an, d.h. sie sind in dem Bündel von Sechskantelementen im Vorleiter voneinander durch mindestens eine Schicht von Sechskantelementen, die nicht Cu-Sechskantelemente sind (und insbesondere im Außenbereich kein elementares Kupfer aufweisen und einen entsprechend großen elektrischen Widerstand besitzen), voneinander getrennt. Die Aufteilung der durch elementares Cu etablierten Strom- und Wärmeleitung auf mehrere (typischerweise mindestens 20) getrennte Cu-Strukturen vermeidet so die Ausbildung von ausgedehnten Kreisströmen innerhalb des Vorleiters.

Dadurch, dass eine Vielzahl von Cu-Strukturen zwischen den CuMn-Kernleiterelementen verteilt angeordnet ist, kann zu jedem CuMn-Kernleiterelement in relativ kurzer Entfernung (quer zur Längsachse des Vorleiters) ein Cu-Sechskantelement zur Verfügung gestellt werden. Die Cu-Strukturen werden dazu bevorzugt gleichmäßig über den Querschnitt des Hüllrohr-Innenraums verteilt. Insbesondere können für die meisten CuMn-Kernleiterelemente durch die Cu-Strukturen kürzere Entfernungen zu elementarem Kupfer zur Verfügung gestellt werden als dies nur durch ein Cu-Hüllrohr und einen Cu-Kern möglich wäre; das erfindungsgemäße Design kann insbesondere zu jedem CuMn-Kernleiterelement mindestens ein benachbartes (angrenzendes) Cu-Sechskantelement vorsehen. Dadurch wird die Stabilisierungswirkung stark verbessert.

Der anspruchsgemäße Querschnitt bezieht sich auf die Ebene senkrecht zur Längsachse (Erstreckungsrichtung) des Vorleiters. Die Cu-Sechskantelemente enthalten typischerweise 30% oder mehr elementares Kupfer, bezogen auf ihre Querschnittsfläche. CuMn bezeichnet im Rahmen der Erfindung, und insbesondere in den Ansprüchen, eine Legierung von Cu mit 0,2 bis 2,0 Gewichts% Mn, bevorzugt 0,4 bis 0,6 Gewichts% Mn, und typischerweise ca. 0,5 Gewichts% Mn. Im Rahmen der Erfindung weist das elementare Kupfer bevorzugt im geglühten Zustand ein Restwiderstandsverhältnis RRR > 100 auf. Man beachte, dass ein dem erfindungsgemäßen Vorleiter entsprechender Drahtaufbau im Rahmen eines Single-Stack-Prozesses auch unmittelbar als Supraleiterdraht verwendet werden kann. Der erfindungsgemäße Vorleiter bzw. ein aus ihm gefertigter Supraleiterdraht kann hervorragend in Anwendungen im magnetischen Wechselfeld, und insbesondere in gepulst betriebenen Magneten, eingesetzt werden.

### Bevorzugte Ausführungsformen der Erfindung

Bei einer bevorzugten Ausführungsform des erfindungsgemäßen Vorleiters ist vorgesehen, dass die Cu-Strukturen im Querschnitt des Vorleiters durch CuMn-Kernleiterelemente voneinander getrennt sind, insbesondere wobei zumindest ein Teil der Cu-Strukturen im Querschnitt des Vorleiters jeweils vollständig von CuMn-Kernleiterelementen umgeben ist. Die Trennung der Cu-Strukturen durch CuMn-Kernleiterelemente gestattet einen hohen Anteil von CuMn-Kernleiterelementen im Bündel und damit auch einen hohen Anteil von NbTi-Supraleitermaterial im Querschnitt des Vorleiters. Es ist auch möglich, die Cu-Strukturen ganz oder teilweise durch andere Sechskantelemente, die keine Cu-Sechskantelemente sind, voneinander zu trennen, etwa durch CuMn-Massivelemente. Bevorzugt ist der überwiegende Teil der Cu-Strukturen, und besonders bevorzugt sind alle Cu-Strukturen vollständig von angrenzenden CuMn-Kernleiterelementen umgeben.

Bevorzugt ist eine Ausführungsform des erfindungsgemäßen Vorleiters, bei der der überwiegende Teil, insbesondere alle oder alle bis auf eine, der Cu-Strukturen aus genau einem Cu-Sechskantelement aufgebaut ist. Durch die Vereinzelung der Cu-Sechskantelemente kann eine sehr gleichmäßige Verteilung des elementaren Kupfers über den Querschnitt des Vorleiters erreicht werden, wodurch die Stabilisierung optimiert wird. Die Entfernungen von einem NbTi-Filament zum nächsten Cu-Sechskantelement können gering gehalten werden; auch werden längere Cu-Strompfade (quer zur Längsrichtung des Vorleiters) automatisch vermieden. Oftmals ist die eine Cu-Struktur aus mehreren Cu-Sechskantelementen zentral im Querschnitt des Vorleiters angeordnet (Kernstruktur), wobei bevorzugt das oder die zentralen Cu-Sechskantelemente als Cu-Massivelemente ausgebildet sind. Dies verbessert das Verformungsverhalten und vermeidet Filamentbrüche beim Strangziehen des Vorleiters.

Besonders bevorzugt ist eine Ausführungsform, die vorsieht, dass im überwiegenden Teil der Querschnittsfläche des Vorleiters gilt:
- ein jedes Cu-Sechskantelement ist im Querschnitt des Vorleiters von sechs CuMn-Kernleiterelementen vollständig umgeben, und
- ein jedes CuMn-Kernleiterelement ist im Querschnitt des Vorleiters von genau drei Cu-Sechskantelementen umgeben, insbesondere symmetrisch umgeben. Dieses Verhältnis von Cu-Sechskantelementen und CuMn-Kernleiterelementen stellt zahlreiche normalleitende Strompfade (parallel zur Längsrichtung) in unmittelbarer Nähe eines jeden CuMn-Kernleiterelements zur Verfügung, ohne dass Cu-Sechskantelemente zueinander benachbart angeordnet zu werden bräuchten. Im Randbereich und/oder Kernbereich des Vorleiters liegen in der Regel Abweichungen von der angegebenen Geometrie vor. Der überwiegende Teil der Querschnittsfläche des Vorleiters umfasst typischerweise 75% oder mehr der Querschnittsfläche.

Bei einer ganz besonders bevorzugten Ausführungsform ist zumindest ein Teil der Cu-Sechskantelemente als Cu-Kernleiterelemente ausgebildet, jeweils mit
- einem NbTi-Filament,
- einer Nb-Barriere, und
- einer Cu-Umhüllung,
insbesondere wobei diese Cu-Kernleiterelemente kein CuMn enthalten. In diesem Fall kann ein besonders großer Flächenanteil des Vorleiters mit dem Supraleiter NbTi beschickt werden; die Umhüllung aus elementarem Kupfer der Cu-Kernleiterelemente stabilisiert den Supraleiter NbTi auch in den benachbarten CuMn-Kernleiterelementen. Man beachte, dass Cu-Kernleiterelemente bevorzugt keine Cu-Strukturen mit weiteren Cu-Kernleiterelementen bilden, um Kopplungen zwischen ihren Filamenten zu vermeiden; Cu-Kernleiterelemente werden bevorzugt allein oder lediglich zusammen mit Cu-Massivelementen in derselben Cu-Struktur eingesetzt. Dadurch werden Strompfade (senkrecht zur Längsachse) nur über Cu zwischen verschiedenen NbTi-Filamenten vermieden. Wenn in diesem Fall die Cu-Strukturen voneinander durch CuMn-Kernleiterelemente voneinander getrennt sind, führt auch für die NbTi-Filamente von Cu-Kernleiterelementen jeder Strompfad zu einem anderen NbTi-Filament des Vorleiters stets auch durch einen Abschnitt aus CuMn, der Kopplungen wirksam verringert. Bevorzugt werden auch Kopplungen von verschiedenen Cu-Kernleiterelementen über ein Cu-Hüllrohr oder Cu-Füllelemente im Randbereich der gebündelten Sechskantelemente eines Vorleiters vermieden, beispielsweise indem die randständigen Sechskantelemente jeweils als CuMn-Kernleiterelemente ausgebildet sind.

Bevorzugt ist auch eine Ausführungsform, bei der zumindest ein Teil der Cu-Sechskantelemente als Cu-Massivelemente ausgebildet ist. Durch die vollständig aus elementarem Kupfer ausgebildeten Cu-Massivelemente können sehr leistungsfähige Strom- und Wärmeleitungspfade zur Verfügung gestellt werden. Der Anteil der Cu-Massivelemente (wie auch der Cu-Strukturen allgemein) kann an die Stabilitätsanforderungen der geplanten Anwendung angepasst werden. Cu-Massivelemente werden insbesondere dann eingesetzt, wenn über Cu-Kernleiterelemente allein die gewünschte Stabilisierung nicht erreicht werden kann, da Cu-Massivelemente eine höhere Leitfähigkeit aufweisen als die relativ dünnwandige Cu-Hülle der Cu-Kernleiterelemente.

Eine weitere, vorteilhafte Ausführungsform sieht vor, dass das Hüllrohr des Vorleiters aus Cu oder CuMn gefertigt ist. Durch ein Cu-Hüllrohr kann ein zusätzlicher Bereich mit guter Normalleitung zur Verbesserung der Stabilisierung zur Verfügung gestellt werden, insbesondere für randständige CuMn-Kernleiterelemente. Durch ein CuMn-Hüllrohr werden verbindende Strompfade über das Hüllrohr für randständige Cu-Strukturen mit Cu-Kernleiterelementen vermieden.

### Erfindungsgemäßer Supraleiter-Draht

In den Rahmen der vorliegenden Erfindung fällt auch ein Supraleiter-Draht, umfassend eine Vielzahl von erfindungsgemäßen Vorleitern. Der erfindungsgemäße Supraleiterdraht profitiert von einer guten Stabilisierung der Supraleitung in den NbTi- Filamenten durch die Cu-Strukturen in den Vorleitern bei gleichzeitig geringen Wechselstromverlusten aufgrund der CuMn-Barrieren, die die Querstrompfade zwischen den NbTi-Filamenten blockieren. Der Supraleiterdraht umfasst typischerweise auch ein Mantelrohr, in dem die Vorleiter gebündelt angeordnet sind. Der Supraleiterdraht kann in einem supraleitenden Kabel verbaut werden. Man beachte, dass ein dem erfindungsgemäßen Supraleiter-Draht entsprechender Aufbau im Rahmen eines Triple-Stack-Prozesses auch als Zwischenstufe für ein weiteres Ziehen und Bündeln verwendet werden kann.

Eine besonders bevorzugte Ausführungsform eines erfindungsgemäßen Supraleiter-Drahtes ist dadurch gekennzeichnet,
- dass der Supraleiter-Draht eine Vielzahl von Sechskantkomponenten umfasst, wobei ein Teil der Sechskantkomponenten als CuMn-Vorleiter, das ist ein Vorleiter mit einem Hüllrohr aus CuMn, ausgebildet ist,
- dass eine Mehrzahl von Cu-Clustern zwischen den CuMn-Vorleitern verteilt angeordnet ist, wobei die Cu-Cluster im Querschnitt des Supraleiter-Drahtes nicht aneinander angrenzen,
- und dass jeder Cu-Cluster aus einer oder mehreren, zueinander benachbarten Cu-Sechskantkomponenten aufgebaut ist,
wobei jede Cu-Sechskantkomponente im Querschnitt einen Flächenanteil von wenigstens 20%, bevorzugt wenigstens 30%, von elementarem Kupfer aufweist. Durch die Mischung von CuMn-Vorleitern und Cu-Clustern kann für alle CuMn-Vorleiter eine kurze Entfernung zu einem Strom- und Wärmeleitungspfad von elementarem Kupfer auf der Ebene der Sechskantkomponenten sichergestellt werden, so dass eine gute Stabilisierung, insbesondere dynamische Stabilisierung, gewährleistet werden kann. Die CuMn-Hüllrohre bilden für Querströme effektive Barrieren aus, so dass Wechselstromverluste wiederum minimiert werden können. Die Größe der CuMn-Vorleiter und der Cu-Sechskantkomponenten ist im Querschnitt im Wesentlichen gleich. Der Querschnitt bezieht sich auf die Ebene senkrecht zur Längsachse (Erstreckungsrichtung) des Supraleiter-Drahtes. Die Cu-Sechskantkomponenten weisen bevorzugt zumindest einen erheblichen Teil ihres elementaren Kupfers in ihrem Außenbereich auf (etwa in einem Cu-Hüllrohr eines Cu-Vorleiters). Die Cu-Cluster grenzen nicht aneinander an, d.h. sie sind in dem Bündel von Sechskantkomponenten im Supraleiterdraht voneinander durch mindestens eine Schicht von Sechskomponenten, die nicht Cu-Sechskomponenten sind (und bevorzugt in ihrem Außenbereich kein elementares Kupfer aufweisen und einen entsprechend großen elektrischen Widerstand besitzen), voneinander getrennt. Die Aufteilung der durch elementares Cu etablierten Strom- und Wärmeleitung auf mehrere (typischerweise mindestens 10) getrennte Cu-Cluster vermeidet so die Ausbildung von ausgedehnten Kreisströmen innerhalb des Supraleiterdrahtes.

In einer bevorzugten Weiterbildung dieser Ausführungsform ist vorgesehen, dass die Cu-Cluster im Querschnitt des Supraleiterdrahtes durch CuMn-Vorleiter voneinander getrennt sind, insbesondere wobei zumindest ein Teil der Cu-Cluster im Querschnitt des Supraleiter-Drahtes vollständig von CuMn-Vorleitern umgeben ist. Die Trennung der Cu-Cluster durch CuMn-Vorleiter gestattet einen hohen Anteil von CuMn-Vorleitern im Bündel und damit auch einen hohen Anteil von NbTi-Supraleitermaterial im Querschnitt des Supraleiterdrahtes. Es ist auch möglich, die Cu-Cluster ganz oder teilweise durch andere Sechskantkomponenten, die keine Cu-Sechskantkomponenten sind, voneinander zu trennen, etwa durch CuMn-Massivkomponenten. Bevorzugt ist der überwiegende Teil der Cu-Cluster, und besonders bevorzugt sind alle Cu-Cluster vollständig von angrenzenden CuMn-Kernleiterelementen umgeben.

Bei einer weiteren, vorteilhaften Weiterbildung dieser Ausführungsform ist zumindest ein Teil der Cu-Sechskantkomponenten als Cu-Vorleiter, das ist ein Vorleiter mit einem Hüllrohr aus Cu, ausgebildet. Dadurch kann ein hoher Anteil des Drahtquerschnitts mit NbTi-Supraleitermaterial gefüllt werden.

Bei einer anderen, vorteilhaften Weiterbildung ist zumindest ein Teil der Cu-Sechskantkomponenten als Cu-Massivkomponenten ausgebildet. Die aus elementarem Kupfer bestehenden Cu-Massivkomponenten können besonders effektiv Strom- und Wärmeleitungspfade parallel zur Längsrichtung des Supraleiterdrahtes zur Verfügung stellen. Der Anteil der Cu-Massivkomponenten kann entsprechend den Stabilitätsanforderungen des Supraleiter-Drahtes gewählt werden.

Eine weitere, bevorzugte Weiterbildung sieht vor, dass der überwiegende Teil, insbesondere alle oder alle bis auf einen, der Cu-Cluster aus genau einer Cu-Sechskantkomponente aufgebaut ist. Die vereinzelten Cu-Sechskantkomponenten können sehr gleichmäßig über den Drahtquerschnitt verteilt werden und so für effektive Stabilisierung sorgen. Oftmals ist ein Cu-Cluster mit mehreren Cu-Sechskantkomponenten zentral im Querschnitt des Supraleiter-Drahtes angeordnet, um die plastischen Verformungseigenschaften beim Drahtziehen zu verbessern und Beschädigungen an NbTi-Filamenten beim Ziehen zu vermeiden. Das oder die zentralen Cu-Sechskantkomponenten sind bevorzugt als Cu-Massivkomponenten ausgebildet.

Bei einer anderen, vorteilhaften Weiterbildung gilt im überwiegenden Teil der Querschnittsfläche des Supraleiter-Drahtes:
- eine jede Cu-Sechskantkomponente ist im Querschnitt des Supraleiter-Drahtes von sechs CuMn-Vorleitern vollständig umgeben, und
- ein jeder CuMn-Vorleiter ist im Querschnitt des Supraleiter-Drahtes von mindestens zwei Cu-Sechskantkomponenten umgeben. Bevorzugt sind dabei die CuMn-Vorleiter von genau zwei oder drei Cu-Sechskantkomponenten umgeben. Der überwiegende Teil der Querschnittsfläche des SL-Drahtes umfasst typischerweise 75% oder mehr der Querschnittsfläche. Bei dieser Verteilung sind kurze Entfernungen von CuMn-Vorleitern zu benachbarten Cu-Sechskantkomponenten gewährleistet, so dass eine-gute Stabilisierung erreicht wird. Gleichzeitig gewährleistet der eingestellte Anteil von CuMn-Vorleitern eine hohe Stromtragfähigkeit des Supraleiterdrahtes.

Bei einer alternativen, ebenfalls vorteilhaften Weiterbildung ist vorgesehen, dass der überwiegende Teil der Cu-Cluster jeweils aus mehreren, kettenförmig benachbarten Cu-Sechskantkomponenten aufgebaut ist, wobei die Cu-Sechskantkomponenten desselben Cu-Clusters in nur einer Bündellage des Supraleiter-Drahtes angeordnet sind, und wobei im überwiegenden Teil der Querschnittsfläche des Supraleiter-Drahtes jede Bündellage des Supraleiter-Drahtes mindestens einen CuMn-Vorleiter, und bevorzugt mindestens sechs CuMn-Vorleiter, aufweist. Die kettenförmig benachbarte Anordnung der Cu-Sechskantkomponenten stellt effektive Pfade für den elektrischen Strom und die Wärmeleitung zu Stabilisierungszwecken zur Verfügung. Die Unterbrechung der Cu-Cluster innerhalb der Bündellagen durch CuMn-Vorleiter (oder alternativ andere Sechskantkomponenten, die nicht Cu-Sechskantkomponenten sind) verhindert effektiv Kreisströme. Der überwiegende Teil der Querschnittsfläche des Supraleiter-Drahtes umfasst typischerweise 75% oder mehr der Querschnittsfläche.

Bevorzugt ist schließlich auch eine Ausführungsform eines erfindungsgemäßen Supraleiter-Drahts, die dadurch gekennzeichnet ist, dass der Supraleiter-Draht ein Mantelrohr aufweist, in welchem die Sechskantkomponenten angeordnet sind, und dass das Mantelrohr aus Cu oder CuMn oder CuNi gefertigt ist. Durch einen Kupfer-Mantelrohr kann eine zusätzliche Stabilisierung erreicht werden; durch CuMn oder CuNi kann die Entkopplung von anderen, benachbarten Supraleiterdrähten (etwa in einem Kabel) verbessert werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Querschnittsdarstellung eines CuMn- Kernleiterelements vor der Sechskantverformung, zur Verwendung in einem erfindungsgemäßen Vorleiter;
- Fig. 2: eine schematische Querschnittsdarstellung eines Cu-Kernleiterelements vor der Sechskantverformung, zur Verwendung in einem erfindungsgemäßen Vorleiter;
- Fig. 3: eine schematische Querschnittsdarstellung eines erfindungsgemäßen CuMn-Vorleiters vor der Sechskantverformung;
- Fig. 4: eine schematische Querschnittsdarstellung eines erfindungsgemäßen Cu-Vorleiters vor der Sechskantverformung mit vereinzelten Cu- Sechskantelementen;
- Fig. 5: eine schematische Darstellung eines erfindungsgemäßen Supraleiterdrahtes, mit mehrheitlich vereinzelten Cu- Sechskantkomponenten;
- Fig. 6: eine schematische Darstellung eines erfindungsgemäßen Supraleiterdrahtes, mit mehrheitlich Cu-Clustern von kettenförmig benachbarten Cu-Vorleitern.

Die vorliegende Erfindung schlägt ein grundsätzlich neues Design von Vorleitern für Supraleiterdrähte auf NbTi-Basis und Supraleiterdrähte auf NbTi-Basis vor. Anstelle von gleichartigen Sechskantelementen in den Vorleitern oder gleichartigen Sechskantkomponenten in den Supraleiterdrähten wird vorgeschlagen, verschiedene Typen von Sechskantelementen und Sechskantkomponenten im überwiegenden Teil des Querschnitts des Vorleiters oder Supraleiterdrahtes zu mischen.

Eine Entkopplung der NbTi-Filamente wird durch eine CuMn-Umhüllung der in der Regel dominierenden CuMn-Kernleiterelemente gewährleistet. Die dynamische und/oder kryogene Stabilisierung wird durch benachbarte Cu-Sechskantelemente für die CuMn-Kernleiterelemente gewährleistet. Bevorzugt weist jedes CuMn-Kernleiterelement mindestens einen, bevorzugt mindestens zwei im Querschnitt benachbarte (angrenzende) Cu-Sechskantelemente auf. Im Rahmen der Erfindung wird insbesondere auch vorgeschlagen, einen Teil (und bevorzugt den überwiegenden Teil) der Cu-Sechskantelemente als Cu-Kernleiterelemente auszubilden.

Auf der Ebene der Vorleiter ist vorgesehen, sechskantige CuMn-Vorleiter und Cu-Sechskantkomponenten zu mischen.

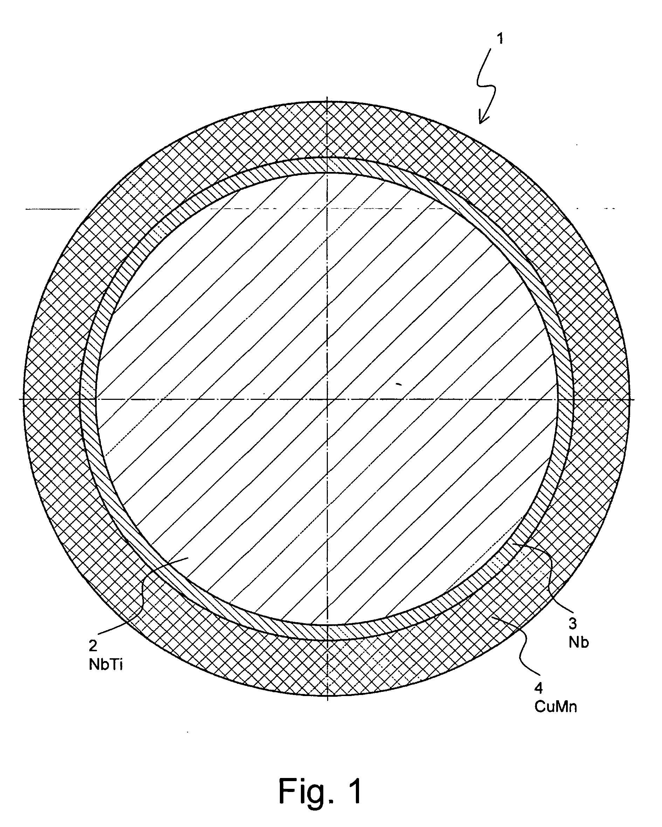

Die Figur 1 zeigt im Querschnitt (senkrecht zur Längsachse) ein CuMn-Kernleiterelement 1 noch vor der Sechskantverformung für einen erfindungsgemäßen Vorleiter. Das CuMn-Kernleiterelement 1 weist ein Filament 2 (auch genannt Kern) aus dem Supraleitermaterial NbTi auf. Das Filament 2 ist umgeben von einer Barriere 3 aus Nb. Um die Barriere 3 herum ist eine Umhüllung 4 aus der Legierung CuMn angeordnet. Die Nb-Barriere 3 verhindert beim Erwärmen des CuMn-Kernleiterelements 1 (was zur Erweichung bei einer plastischen Verformung erfolgt) die Bildung von spröden intermetallischen CuTi-Ausscheidungen. Die im Rahmen der Erfindung verbauten CuMn-Kernleiterelemente 1 weisen insbesondere keine Schicht aus elementarem (hochreinem) Kupfer auf: Eine solche weitere Schicht würde die Produktion der CuMn-Kernleiterelemente erschweren und erheblich verteuern.

Das CuMn-Kernleiterelement 1 wird Press- und/oder Ziehverfahren unterzogen und insbesondere auf eine im Querschnitt sechskantige Gestalt umgeformt, um ein nachfolgendes Bündeln zu einem Vorleiter vorzubereiten.

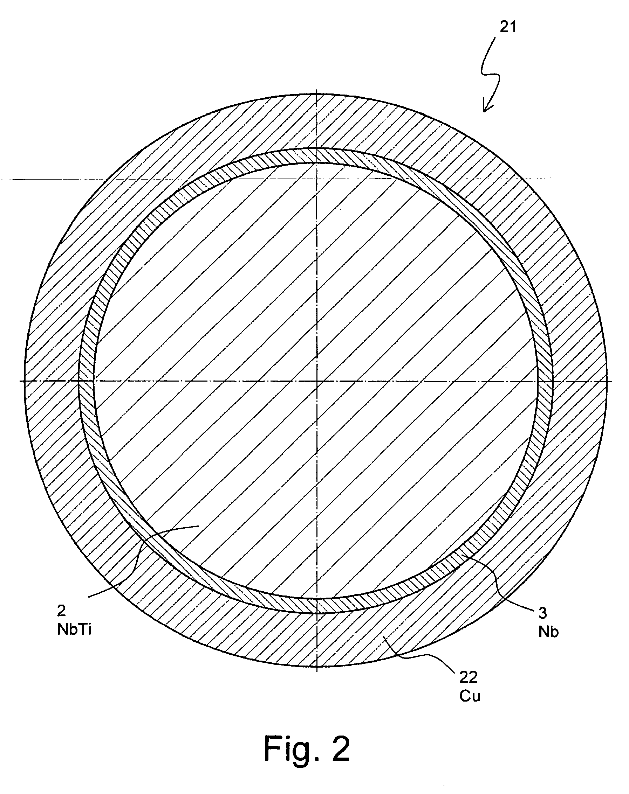

Die Figur 2 zeigt im Querschnitt ein Cu-Kernleiterelement 21 noch vor einer Sechskantverformung für einen erfindungsgemäßen Vorleiter. Das Cu-Kernleiterelement 21 weist ebenfalls ein Filament 2 aus dem Supraleitermaterial NbTi auf. Das Filament 2 ist wiederum umgeben von einer Barriere 3 aus Nb. Um die Barriere 3 herum ist eine Umhüllung 22 aus der elementarem Kupfer angeordnet.

Das Cu-Kernleiterelement 21 wird ebenfalls Press- und/oder Ziehverfahren unterzogen und insbesondere auf eine im Querschnitt sechskantige Gestalt umgeformt, um ein nachfolgendes Bündeln zu einem Vorleiter vorzubereiten.

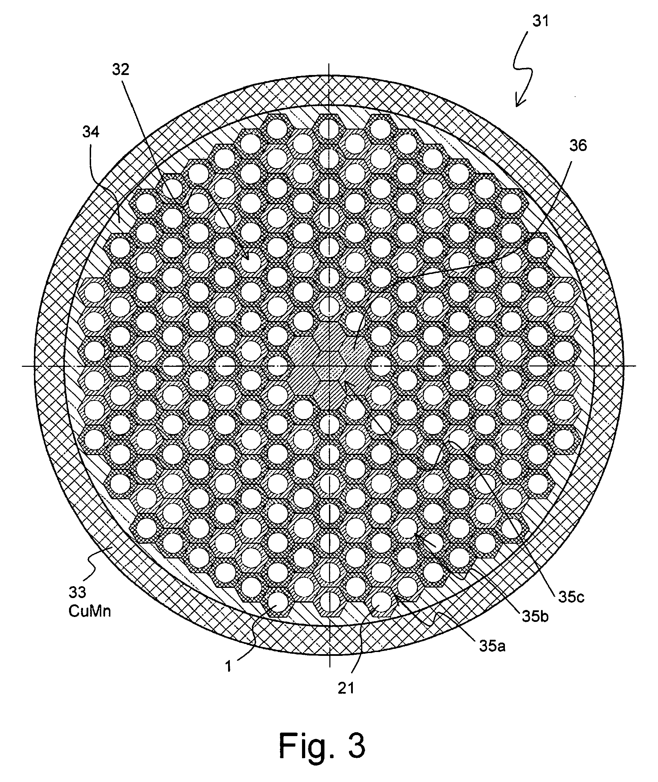

Die Figur 3 zeigt im Querschnitt (senkrecht zur Längsachse) einen erfindungsgemäßen CuMn-Vorleiter 31 noch vor einer Sechskantverformung. Der Vorleiter 31 umfasst eine Vielzahl von Sechskantelementen 32, die gebündelt in einem Hüllrohr 33 angeordnet sind; das Hüllrohr 33 ist in der gezeigten Ausführungsform aus CuMn gefertigt (daher auch die Bezeichnung CuMn-Vorleiter 31). Am inneren Rand des Hüllrohres 33 sind Füllbauteile 34 aus Cu angeordnet, um einen spielfreien Sitz der Sechskantelemente 32 im Hüllrohr 33 sicherzustellen.

Der ganz überwiegende Teil der Sechskantelemente 32 ist als CuMn-Kernleiterelemente 1 (vgl. quadratische Außenschraffur; das NbTi-Filament ist als weiße Kreisfläche angedeutet) ausgebildet.

Verteilt unter den CuMn-Kernleiterelementen 1 sind verschiedene Cu-Strukturen 35a, 35b, 35c. Jede Cu-Struktur 35a, 35b, 35c besteht aus einem Cu-Sechskantelement oder mehreren, zueinander benachbarten (aneinander angrenzenden) Cu-Sechskantelementen. Unter Cu-Sechskantelement wird hierbei ein Sechskantelement 32, das elementares Kupfer enthält, verstanden. Alle Sechskantelemente 32, die einer der Cu-Strukturen 35a-35c benachbart angeordnet sind (also eine der Cu-Strukturen 35a-35c im Bündel umgeben), sind dabei CuMn-Kernleiterelemente 1, wodurch hier die CuMn-Kernleiterelemente 1 die Cu-Strukturen 35a, 35b, 35c voneinander trennen.

Die Cu-Strukturen 35a bestehen hierbei aus drei zueinander benachbarten Cu-Kernleiterelementen 21 (vgl. die Außenschraffur paralleler Linien; das NbTi-Filament ist wiederum als weiße Kreisfläche angedeutet); man beachte, dass diese gezeigten Cu-Strukturen 35a teilweise randständig angeordnet sind und in diesem Fall nicht vollständig von angrenzenden CuMn-Kernleiterelementen 1 umgeben sein können. Die Cu-Strukturen 35b bestehen hier jeweils nur aus einem Cu-Kernleiterelement 21. Die Cu-Struktur 35c im Zentrum des Vorleiters 31 besteht aus sieben Cu-Massivelementen 36 und drei Cu-Kernleiterelementen 21. Die Cu-Massivelemente 36 bestehen aus elementarem Kupfer. Die Cu-Strukturen 35b und 35c sind erfindungsgemäß jeweils vollständig von angrenzenden CuMn-Kernleiterelementen 1 umgeben.

Man beachte, dass ein erfindungsgemäßer Vorleiter typischerweise zwischen 100 und 450 Sechskantelemente umfasst, wobei typischerweise zwischen 20 und 150 Cu-Strukturen ausgebildet werden.

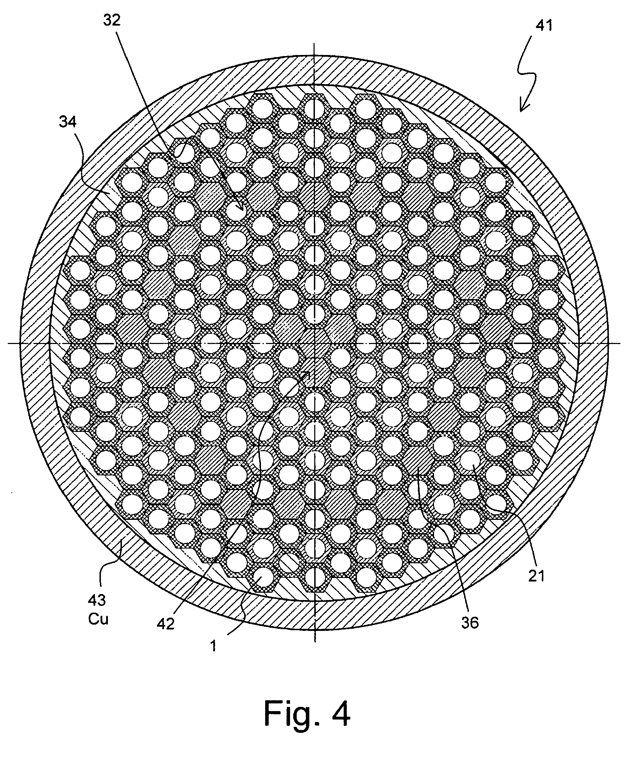

Die Figur 4 zeigt im schematischen Querschnitt einen erfindungsgemäßen Cu-Vorleiter 41 vor einer Sechskantverformung. Der Cu-Vorleiter 41 weist ein Hüllrohr 43 aus Cu auf (daher die Bezeichnung Cu-Vorleiter 41). Im Inneren des Hüllrohres 43 sind wiederum gebündelte Sechskantelemente 32 angeordnet.

Zwischen den CuMn-Kernleiterelementen 1 sind hier (mit Ausnahme der zentralen Cu-Struktur 42, die aus vier Cu-Massivelementen besteht) einzelne Cu-Sechskantelemente verteilt angeordnet. Dabei sind sowohl einzelne Cu-Massivelemente 36 als auch einzelne Cu-Kernleiterelemente 21 vorgesehen.

Mit Ausnahme der zentralen Cu-Struktur 42 ist hier jedes Cu-Sechskantelement von sechs CuMn-Kernleiterelementen 1 umgeben. Die CuMn-Kernleiterelemente 1 (mit Ausnahme einiger CuMn-Kernleiterelemente 1, die an die zentrale Cu-Struktur 42 angrenzen oder nahe am Rand zum Hüllrohr 43 angeordnet sind) sind jeweils von genau drei Cu-Sechskantelementen umgeben. Man beachte, dass in dieser Ausführungsform der äußere Rand des Bündels der Sechskantelemente 32 zum Cu-Hüllrohr 43 hin ausschließlich von CuMn-Kernleiterelementen 1 gebildet wird, so dass eine Kopplung von NbTi-Filamenten über das Cu-Hüllrohr 43 oder die Füllbauteile 34 ausgeschlossen ist.

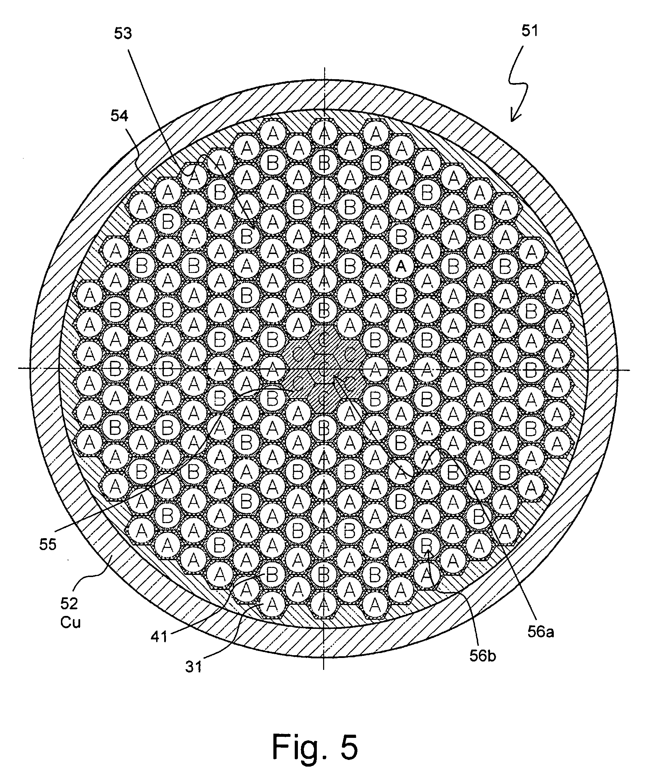

In der Figur 5 ist im schematischen Querschnitt (senkrecht zur Längsachse) ein erfindungsgemäßer Supraleiter-Draht 51 dargestellt. Der Supraleiter-Draht 51 verfügt über ein Mantelrohr 52, welches in der gezeigten Ausführungsform aus Kupfer gefertigt ist. Im Inneren des Mantelrohrs 52 ist ein Bündel von Sechskantkomponenten 53 angeordnet. Am Mantelrohr 52 innen liegen Füllbauteile 54 an, so dass die Sechskantkomponenten 53 spielfrei gehalten sind.

In der gezeigten Ausführungsform sind drei verschiedene Typen von Sechskantkomponenten 53 verbaut. Der überwiegende Teil der Sechskantkomponenten 53 ist als CuMn-Vorleiter 31 (also erfindungsgemäße Vorleiter mit CuMn-Hüllrohr, vgl. beispielsweise Fig. 3) ausgebildet; die CuMn-Vorleiter 31 sind zusätzlich mit dem Buchstaben "A" markiert. Insbesondere sind alle Sechskantkomponenten 53, die am äußeren Rand des Bündels angeordnet sind, CuMn-Vorleiter 31. Zwischen den CuMn-Vorleitern 31 gleichmäßig über den Querschnitt des Innenraums des Mantelrohrs 52 verteilt sind Cu-Vorleiter 41 (also erfindungsgemäße Vorleiter mit Cu-Hüllrohr, vgl. beispielsweise Fig. 4) angeordnet; die Cu-Vorleiter 41 sind zusätzlich mit dem Buchstaben "B" markiert. Im Zentrum des Supraleiter-Drahtes 51 ist ein Kernbereich mit sieben Cu-Massivkomponenten 55, also Sechskantkomponenten bestehend aus elementarem Kupfer, ausgebildet; die Cu-Massivkomponenten 55 sind zusätzlich mit dem Buchstaben "C" markiert.

Die Cu-Massivkomponenten 55 und die Cu-Vorleiter 41 stellen die Cu-Sechskantkomponenten dieser Ausführungsform dar, denn sie weisen einen Gehalt von elementarem Cu von 20% oder mehr in der Querschnittsfläche auf (Gehalt an elementarem Cu in der Querschnittsfläche im Ausführungsbeispiel: Cu-Vorleiter ca. 31 %, Cu-Massivkomponente 100%, CuMn-Vorleiter ca. 19%). In dieser Ausführungsform, und auch allgemein im Rahmen der Erfindung, stellen die CuMn-Vorleiter 31 aufgrund ihres niedrigen Gehalts an elementarem Kupfer keine Cu-Sechskantkomponenten dar.

Die sieben Cu-Massivkomponenten 55 bilden zusammen mit den sechs benachbarten Cu-Vorleitern 41 ein großes zentrales Cu-Cluster 56a. Die übrigen Cu-Vorleiter 41 bilden jeweils Cu-Cluster 56b bestehend aus nur einem Cu-Vorleiter 41 aus. Ein Cu-Cluster 56a, 56b besteht dabei aus einer oder mehreren benachbarten Cu-Sechskantkomponenten.

Vom äußeren Randbereich des Bündels und dem Bereich am zentralen Cu-Cluster 56a abgesehen hat hier jeder CuMn-Vorleiter 31 im Querschnitt genau zwei oder genau drei benachbarte (umgebende) Cu-Sechskantkomponenten.

Die Figur 6 zeigt im schematischen Querschnitt einen weiteren erfindungsgemäßen Supraleiter-Draht 61. Auch dieser Supraleiterdraht 61 weist ein Mantelrohr 52 aus elementarem Kupfer auf, in dem eine Vielzahl von Sechskantkomponenten 53 hexagonal bebündelt angeordnet ist. Die Sechskantkomponenten 53 umfassen wiederum CuMn-Vorleiter 31 bzw. "A", Cu-Vorleiter 41 bzw. "B", und Cu-Massivkomponenten 55 bzw. "C".

Der Supraleiter-Draht 61 weist Cu-Cluster verschiedener Größen auf, teilweise bestehend aus nur einem Cu-Vorleiter 41 oder auch bestehend aus sieben Cu-Massivkomponenten 55 und zwölf Cu-Vorleitern 41 beim zentralen Cu-Cluster 56a. Der größte Teil der Cu-Cluster ist hier jedoch aus mehreren, kettenartig benachbarten Cu-Sechskantelementen (hier Cu-Vorleitern 41) aufgebaut, wobei alle Cu-Sechskantelemente desselben Cu-Clusters in derselben (sechseckig-ringförmigen) Bündellage liegen.

Zur Veranschaulichung wurde auf der Achse 61 ein Index (vgl. indexierte Punkte) für die Bündellagen, gezählt vom zentralen Sechskantelement, eingezeichnet. In der fünften Bündellage sind beispielsweise vier Cu-Cluster 63 (vgl. Doppellinie), jeweils umfassend fünf Cu-Vorleiter 41 (hier "über Eck" verlaufend), angeordnet. Die vier Cu-Cluster 63 werden in der fünften Bündellage von vier einzelnen CuMn-Vorleitern 31 voneinander getrennt. In der siebten Bündellage sind insgesamt sechs Cu-Cluster 64, jeweils umfassend fünf Cu-Vorleiter 41, angeordnet; ebenso sind insgesamt sechs Cu-Cluster 65, jeweils umfassend fünf Cu-Vorleiter 41, in der neunten Bündellage angeordnet.

Erfindungsgemäße Supraleiterdrähte werden bevorzugt so stark gezogen, dass die NbTi-Filamente einen Durchmesser von 1 bis 3 µm, besonders bevorzugt ca. 2 µm erreichen.

Man beachte, dass die Erfindung - unabhängig von der vorhergehenden Beschreibung - sich auch manifestiert in
einem Vorleiter zum Aufbau eines Supraleiterdrahtes, umfassend eine Vielzahl von Sechskantelementen und ein Hüllrohr, in welchem die Sechskantelemente angeordnet sind,
wobei ein erster Teil der Sechskantelemente ausgebildet ist als CuMn-Kernleiterelemente, jeweils mit einem NbTi-Filament, einer Nb-Barriere und einer CuMn-Umhüllung, wobei die CuMn-Kernleiterelemente frei sind von elementarem Kupfer,
und wobei ein zweiter Teil der Sechskantelemente ausgebildet ist als Cu-Kernleiterelemente, jeweils mit einem NbTi-Filament, einer Nb-Barriere und einer Cu-Umhüllung. Die Cu-Kernleiterelemente sind bevorzugt gleichmäßig verteilt in den CuMn-Kernleiterelementen angeordnet, insbesondere so dass der größte Teil oder alle der Cu-Kernleiterelemente im Querschnitt jeweils vollständig von (angrenzenden) CuMn-Kernleiterelementen umgeben ist. Es können zusätzlich weitere Sechskantelemente im Vorleiter vorgesehen sein, insbesondere Cu-Massivelemente.

## Patentansprüche

1. Vorleiter (31; 41) zum Aufbau eines Supraleiter-Drahtes (51; 61), umfassend
- eine Vielzahl von Sechskantelementen (32), und
- ein Hüllrohr (33; 43), in welchem die Sechskantelemente (32) angeordnet sind,
wobei ein Teil der Sechskantelemente (32) als CuMn-Kernleiterelemente (1) ausgebildet sind, jeweils mit
- einem NbTi-Filament (2),
- einer Nb-Barriere (3) und
- einer CuMn-Umhüllung (4),
wobei diese CuMn-Kernleiterelemente (1) kein elementares Kupfer enthalten,
**dadurch gekennzeichnet,**
**dass** eine Mehrzahl von Cu-Strukturen (35a-35c; 42) zwischen den CuMn-Kernleiterelementen (1) verteilt angeordnet ist, wobei die Cu-Strukturen (35a-35c; 42) im Querschnitt des Vorleiters (31; 41) nicht aneinander angrenzen, und dass jede Cu-Struktur (35a-35c; 42) aus einem Cu-Sechskantelement, das ist ein Sechskantelement (32) enthaltend elementares Kupfer, oder mehreren zueinander benachbarten Cu-Sechskantelementen aufgebaut ist.

2. Vorleiter (31; 41) nach Anspruch 1, **dadurch gekennzeichnet, dass** die Cu-Strukturen (35a-35c; 42) im Querschnitt des Vorleiters (31; 41) durch CuMn-Kernleiterelemente (1) voneinander getrennt sind,
insbesondere wobei zumindest ein Teil der Cu-Strukturen (35a-35c; 42) im Querschnitt des Vorleiters (31; 41) jeweils vollständig von CuMn-Kernleiterelementen (1) umgeben ist.

3. Vorleiter (31; 41) nach Anspruch 1 oder 2, **dadurch gekennzeichnet, dass** der überwiegende Teil, insbesondere alle oder alle bis auf eine, der Cu-Strukturen (35a-35c; 42) aus genau einem Cu-Sechskantelement aufgebaut ist.

4. Vorleiter (31; 41) nach Anspruch 1, 2 oder 3, **dadurch gekennzeichnet, dass** im überwiegenden Teil der Querschnittsfläche des Vorleiters (31; 41) gilt:
- ein jedes Cu-Sechskantelement ist im Querschnitt des Vorleiters (31; 41) von sechs CuMn-Kernleiterelementen (1) vollständig umgeben, und
- ein jedes CuMn-Kernleiterelement (1) ist im Querschnitt des Vorleiters (31; 41) von genau drei Cu-Sechskantelementen umgeben, insbesondere symmetrisch umgeben.

5. Vorleiter (31; 41) nach einem der vorhergehenden Ansprüche, **dadurch gekennzeichnet, dass** zumindest ein Teil der Cu-Sechskantelemente als Cu-Kernleiterelemente (21) ausgebildet ist, jeweils mit
- einem NbTi-Filament (2),
- einer Nb-Barriere (3), und
- einer Cu-Umhüllung (22),
insbesondere wobei diese Cu-Kernleiterelemente (21) kein CuMn enthalten.

6. Vorleiter (31; 41) nach einem der vorhergehenden Ansprüche, **dadurch gekennzeichnet, dass** zumindest ein Teil der Cu-Sechskantelemente als Cu-Massivelemente (36) ausgebildet ist.

7. Vorleiter (31; 41) nach einem der vorhergehenden Ansprüche, **dadurch gekennzeichnet, dass** das Hüllrohr (33; 43) des Vorleiters (31; 41) aus Cu oder CuMn gefertigt ist.

8. Supraleiter-Draht (51; 61), umfassend eine Vielzahl von Vorleitern (31; 41) nach einem der vorhergehenden Ansprüche.

9. Supraleiter-Draht (51; 61) nach Anspruch 8, **dadurch gekennzeichnet,**
- **dass** der Supraleiter-Draht (51; 61) eine Vielzahl von Sechskantkomponenten (53) umfasst,
wobei ein Teil der Sechskantkomponenten (53) als CuMn-Vorleiter (31), das ist ein Vorleiter (31; 41) mit einem Hüllrohr (33) aus CuMn, ausgebildet ist,
- **dass** eine Mehrzahl von Cu-Clustern (56a-56b; 63-65) zwischen den CuMn-Vorleitern (31) verteilt angeordnet ist, wobei die Cu-Cluster (56a-56b; 63-65) im Querschnitt des Supraleiter-Drahtes (51; 61) nicht aneinander angrenzen,
- und **dass** jeder Cu-Cluster (56a-56b; 63-65) aus einer oder mehreren, zueinander benachbarten Cu-Sechskantkomponenten aufgebaut ist,
wobei jede Cu-Sechskantkomponente im Querschnitt einen Flächenanteil von wenigstens 20%, bevorzugt wenigstens 30%, von elementarem Kupfer aufweist.

10. Supraleiter-Draht (51; 61) nach Anspruch 9, **dadurch gekennzeichnet, dass** die Cu-Cluster (56a-56b; 63-65) im Querschnitt des Supraleiterdrahtes (51; 61) durch CuMn-Vorleiter (31) voneinander getrennt sind,
insbesondere wobei zumindest ein Teil der Cu-Cluster (56a-56b; 63-65) im Querschnitt des Supraleiter-Drahtes (51; 61) vollständig von CuMn-Vorleitern (31) umgeben ist.

11. Supraleiter-Draht (51; 61) nach Anspruch 9 oder 10, **dadurch gekennzeichnet, dass** zumindest ein Teil der Cu-Sechskantkomponenten als Cu-Vorleiter (41), das ist ein Vorleiter (31; 41) mit einem Hüllrohr (43) aus Cu, ausgebildet ist.

12. Supraleiter-Draht (51; 61) nach einem der Ansprüche 9, 10 oder 11, **dadurch gekennzeichnet, dass** zumindest ein Teil der Cu-Sechskantkomponenten als Cu-Massivkomponenten (55) ausgebildet ist.

13. Supraleiter-Draht (51; 61) nach einem der Ansprüche 9 bis 12, **dadurch gekennzeichnet, dass** der überwiegende Teil, insbesondere alle oder alle bis auf einen, der Cu-Cluster (56a-56b; 63-65) aus genau einer Cu-Sechskantkomponente aufgebaut ist.

14. Supraleiter-Draht (51; 61) nach einem der Ansprüche 9 bis 13, **dadurch gekennzeichnet, dass** im überwiegenden Teil der Querschnittsfläche des Supraleiter-Drahtes (51; 61) gilt:
- eine jede Cu-Sechskantkomponente ist im Querschnitt des Supraleiter-Drahtes (51; 61) von sechs CuMn-Vorleitern (31) vollständig umgeben, und
- ein jeder CuMn-Vorleiter (31) ist im Querschnitt des Supraleiter-Drahtes (51; 61) von mindestens zwei Cu-Sechskantkomponenten umgeben.

15. Supraleiter-Draht (51; 61) nach einem der Ansprüche 9 bis 12, **dadurch gekennzeichnet,**
**dass** der überwiegende Teil der Cu-Cluster (56a-56b; 63-65) jeweils aus mehreren, kettenförmig benachbarten Cu-Sechskantkomponenten aufgebaut ist, wobei die Cu-Sechskantkomponenten desselben Cu-Clusters (56a-56b; 63-65) in nur einer Bündellage des Supraleiter-Drahtes (51; 61) angeordnet sind,
und wobei im überwiegenden Teil der Querschnittsfläche des Supraleiter-Drahtes (51; 61) jede Bündellage des Supraleiter-Drahtes (51; 61) mindestens einen CuMn-Vorleiter (31), und bevorzugt mindestens sechs CuMn-Vorleiter (31), aufweist.

16. Supraleiter-Draht (51; 61) nach einem der Ansprüche 8 bis 15, **dadurch gekennzeichnet, dass** der Supraleiter-Draht (51; 61) ein Mantelrohr (52) aufweist, in welchem die Sechskantkomponenten (53) angeordnet sind, und dass das Mantelrohr (52) aus Cu oder CuMn oder CuNi gefertigt ist.

## Claims

1. Conductor precursor (31; 41) for forming a superconducting wire (51; 61), comprising
- a plurality of hexagonal elements (32), and
- a cladding tube (33; 43), in which the hexagonal elements (32) are arranged,
wherein part of the hexagonal elements (32) are formed as CuMn core conductor elements (1), each having
- an NbTi filament (2),
- an Nb barrier (3), and
- a CuMn cladding (4),
wherein these CuMn core conductor elements (1) do not contain elemental copper,
**characterized in that**
a plurality of Cu structures (35a-35c; 42) are distributed between the CuMn core conductor elements (1), wherein the Cu structures (35a-35c; 42) do not border one another in the cross-section of the conductor precursor (31; 41), and each Cu structure (35a-35c; 42) is formed from a Cu hexagonal element, i.e. a hexagonal element (32) containing elemental copper, or several neighboring Cu hexagonal elements.

2. Conductor precursor (31; 41) according to claim 1, **characterized in that** the Cu structures (35a-35c; 42) are separated from each other in the cross-section of the conductor precursor (31; 41) by CuMn core conductor elements (1), in particular, wherein at least part of the Cu structures (35a-35c; 42) are completely surrounded by CuMn core conductor elements (1) each in the cross-section of the conductor precursor (31; 41).

3. Conductor precursor (31; 41) according to claim 1 or 2, **characterized in that** the major part, in particular, all or all except for one of the Cu structures (35a-35c; 42) are formed from exactly one Cu hexagonal element.

4. Conductor precursor (31; 41) according to claim 1, 2 or 3, **characterized in that** the following applies for the major part of the cross-sectional area of the conductor precursor (31; 41):
- each Cu hexagonal element is completely surrounded by six CuMn core conductor elements (1) in the cross-section of the conductor precursor (31; 41); and
- each CuMn core conductor element (1) is surrounded, in particular symmetrically, by exactly three Cu hexagonal elements in the cross-section of the conductor precursor (31; 41).

5. Conductor precursor (31; 41) according to any one of the preceding claims, **characterized in that** at least part of the Cu hexagonal elements are formed as Cu core conductor elements (21), each having
- an NbTi filament (2),
- an Nb barrier (3), and
- a Cu cladding (22),
in particular, wherein these Cu core conductor elements (21) do not contain CuMn.

6. Conductor precursor (31; 41) according to any one of the preceding claims, **characterized in that** at least part of the Cu hexagonal elements are formed as Cu massive elements (36).

7. Conductor precursor (31; 41) according to any one of the preceding claims, **characterized in that** the cladding tube (33; 43) of the conductor precursor (31; 41) is made from Cu or CuMn.

8. Superconducting wire (51; 61) comprising a plurality of conductor precursors (31; 41) according to any one of the preceding claims.

9. Superconducting wire (51; 61) according to claim 8, **characterized in that**
- the superconducting wire (51; 61) comprises a plurality of hexagonal components (53),
wherein part of the hexagonal components (53) are formed as CuMn conductor precursors (31), i.e. a conductor precursor (31; 41) comprising a cladding tube (33) of CuMn,
- a plurality of Cu clusters (56a-56b; 63-65) are distributed between the CuMn conductor precursors (31), wherein the Cu clusters (56a-56b, 63-65) do not border one another in the cross-section of the superconducting wire (51; 61),
- and each Cu cluster (56a-56b; 63-65) is formed from one or more neighboring Cu hexagonal components, wherein each Cu hexagonal component has a cross-sectional area portion of elemental copper of at least 20%, preferably at least 30%.

10. Superconducting wire (51; 61) according to claim 9, **characterized in that** the Cu clusters (56a-56b, 63-65) are separated from each other by CuMn conductor precursors (31) in the cross-section of the superconducting wire (51; 61), in particular, wherein at least part of the Cu clusters (56a-56b; 63-65) are completely surrounded by CuMn conductor precursors (31) in the cross-section of the superconducting wire (51; 61).

11. Superconducting wire (51; 61) according to claim 9 or 10; **characterized in that** at least part of the Cu hexagonal components are formed as Cu conductor precursor (41), i.e. a conductor precursor (31; 41) comprising a cladding tube (43) of Cu.

12. Superconducting wire (51; 61) according to any one of the claims 9, 10 or 11, **characterized in that** at least part of the Cu hexagonal components are formed as Cu massive components (55).

13. Superconducting wire (51; 61) according to any one of the claims 9 through 12, **characterized in that** the major part, in particular, all or all except for one of the Cu clusters (56a-56b; 63-65) are formed from exactly one Cu hexagonal component.

14. Superconducting wire (51; 61) according to any one of the claims 9 through 13, **characterized in that** the following applies for the major part of the cross-sectional area of the superconducting wire (51; 61):
- each Cu hexagonal component is completely surrounded by six CuMn conductor precursors (31) in the cross-section of the superconducting wire (51; 61), and
- each CuMn conductor precursor (31) is surrounded by at least two Cu hexagonal components in the cross-section of the superconducting wire (51; 61).

15. Superconducting wire (51; 61) according to any one of the claims 9 through 12, **characterized in that**
the major part of the Cu clusters (56a-56b; 63-65) are formed from several chain-like neighboring Cu hexagonal components each, wherein the Cu hexagonal components of the same Cu cluster (56a-56b; 63-65) are disposed in only one bundle layer of the superconducting wire (51; 61),
and wherein in the major part of the cross-sectional area of the superconducting wire (51; 61), each bundle layer of the superconducting wire (51; 61) has at least one CuMn conductor precursor (31) and preferably at least six CuMn conductor precursors (31).

16. Superconducting wire (51; 61) according to any one of the claims 8 through 15, **characterized in that** the superconducting wire (51; 61) has a jacket tube (52), in which the hexagonal components (53) are arranged, and **in that** the jacket tube (52) is produced from Cu or CuMn or CuNi.

## Revendications

1. Fil précurseur (31 ; 41) pour la construction d'un fil supraconducteur (51 ; 61), comprenant
- une pluralité d'éléments hexagonaux (32) et
- une gaine tubulaire (33 ; 43) dans laquelle les éléments hexagonaux (32) sont disposés,
une partie des éléments hexagonaux (32) étant réalisée sous la forme d'éléments conducteurs centraux en CuMn (1), comportant chacun
- un filament en NbTi (2),
- une barrière en Nb (3) et
- une gaine en CuMn (4),
Ces éléments conducteurs centraux en CuMn (1) ne contenant pas de cuivre élémentaire,
**caractérisé en ce**
**qu'**une pluralité de structures en Cu (35a-35c ; 42) est répartie entre les éléments conducteurs centraux en CuMn (1), les structures en Cu (35a-35c ; 42) n'étant pas contiguës en coupe transversale du fil précurseur (31 ; 41), et que chaque structure en Cu (35a-35c ; 42) est constituée d'un élément hexagonal en Cu, c'est-à-dire un élément hexagonal (32) contenant du cuivre élémentaire, ou de plusieurs éléments hexagonaux en Cu adjacents les uns aux autres.

2. Fil précurseur (31 ; 41) selon la revendication 1, **caractérisé en ce que** les structures en Cu (35a-35c ; 42) sont séparées les unes des autres en section transversale du fil précurseur (31 ; 41) par des éléments conducteurs centraux en CuMn (1),
en particulier au moins une partie des structures en Cu (35a-35c ; 42) étant, en section transversale du fil précurseur (31 ; 41), chaque fois complètement entourée par des éléments conducteurs centraux en CuMn (1).

3. Fil précurseur (31 ; 41) selon la revendication 1 ou 2, **caractérisé en ce que** la majeure partie, en particulier toutes ou toutes sauf une des structures en Cu 1(35a-35c ; 42) est constituée d'exactement un élément hexagonal en Cu.

4. Fil précurseur (31 ; 41) selon la revendication 1, 2 ou 3, **caractérisé en ce que** dans la majeure partie de la surface de section du fil précurseur (31 ; 41) :
- chaque élément hexagonal en Cu est, en section transversale du fil précurseur (31 ; 41), complètement entouré par six éléments conducteurs centraux en CuMn (1) et
- chaque élément conducteur central en CuMn (1) est, en section transversale du fil précurseur (31; 41), entouré par exactement trois éléments hexagonaux en Cu, en particulier entouré symétriquement.

5. Fil précurseur (31 ; 41) selon une des revendications précédentes, **caractérisé en ce qu'**au moins une partie des éléments hexagonaux en Cu est réalisée sous la forme d'éléments conducteurs centraux en CuMn (21), comportant chacun
- un filament en NbTi (2),
- une barrière en Nb (3) et
- une gaine en Cu (22),
ces éléments conducteurs centraux en CuMn (21) ne contenant en particulier pas de CuMn.

6. Fil précurseur (31 ; 41) selon une des revendications précédentes, **caractérisé en ce qu'**au moins une partie des éléments hexagonaux en Cu est réalisée sous la forme d'éléments massifs en Cu (36).

7. Fil précurseur (31 ; 41) selon une des revendications précédentes, **caractérisé en ce que** la gaine tuliulaire (33 ; 43) du fil précurseur (31 ; 41) est réalisée en Cu ou CuMn.

8. Fil supraconducteur (51 ; 61), comprenant une pluralité de fils précurseurs (31 ; 41) selon une des revendications précédentes.

9. Fil supraconducteur (51 ; 61) selon la revendication 8, **caractérisé en ce**
- **que** le fil supraconducteur (51 ; 61) comprend une pluralité de composants hexagonaux (53),
une partie des composants hexagonaux (53) étant réalisée sous la forme de fils précurseurs en CuMn (31), c'est-à-dire de fils précurseurs (31 ; 41) avec une gaine tubulaire (33) en CuMn,
- **qu'**une pluralité de clusters en Cu (56a-56b ; 63-65) est répartie entre les fils précurseurs en CuMn (31), les clusters en Cu (56a-56b ; 63-65) n'étant pas contigus les uns aux autres en section transversale du fil supraconducteur (51 ; 61),
- et **que** chaque cluster en Cu (56a-56b ; 63-65) est constitué d'un ou plusieurs composants hexagonaux en Cu adjacents les uns aux autres,
chaque composant hexagonal en Cu présentant, en section transversale, une part de surface d'au 20 %, de préférence d'au moins 30 %, en cuivre élémentaire.

10. Fil supraconducteur (51 ; 61) selon la revendication 9, **caractérisé en ce que** les clusters en Cu (56a-56b ; 63-65) sont séparés les uns des autres, en section transversale du fil supraconducteur (51 ; 61), par des fils précurseurs en CuMn (31), en particulier au moins une partie des clusters en Cu (56a-56b ; 63-65) étant, en section transversale du fil supraconducteur (51 ; 61), complètement entourée par des fils précurseurs en CuMn (31).

11. Fil supraconducteur (51 ; 61) selon la revendication 9 ou 10, **caractérisé en ce qu'**au moins une partie des composants hexagonaux en Cu est réalisée sous la forme de fils précurseurs en Cu (41), c'est-à-dire de fils précurseurs (31 ; 41) avec une gaine tubulaire (43) en Cu.

12. Fil supraconducteur (51 ; 61) selon une des revendications 9, 10 ou 11, **caractérisé en ce qu'**au moins une partie des composants hexagonaux en Cu est réalisée sous la forme de composants massifs en Cu (55).

13. Fil supraconducteur (51 ; 61) selon une des revendications 9 à 12, **caractérisé en ce que** la majeure partie, en particulier tous ou tous sauf un des clusters en Cu (56a-56b ; 63-65) est constituée d'exactement un composant hexagonal en Cu.

14. Fil supraconducteur (51 ; 61) selon une des revendications 9 à 13, **caractérisé en ce que** dans la majeure partie de la surface de section du fil supraconducteur (51 ; 61) :
- chaque composant hexagonal en Cu est, en section transversale du fil supraconducteur (51 ; 61), complètement entouré par six fils précurseurs en CuMn (31), et
- chaque fil précurseur en CuMn (31) est, en section transversale du fil supraconducteur (51 ; 61), entouré par au moins deux composants hexagonaux en Cu.

15. Fil supraconducteur (51 ; 61) selon une des revendications 9 à 12, **caractérisé en ce que** la majeure partie des clusters en Cu (56a-56b ; 63-65) est constituée de plusieurs composants hexagonaux en Cu adjacents en forme de chaîne, les composants hexagonaux en Cu du même cluster en Cu (56a-56b ; 63-65) étant disposés dans seulement un emplacement de faisceau du fil supraconducteur (51; 61),
et chaque emplacement de faisceau du fil supraconducteur (51 ; 61) présentant, dans la majeure partie de la surface de section du fil supraconducteur (51 ; 61), au moins un fil précurseur en CuMn (31) et de préférence au moins six fils précurseurs en CuMn (31).

16. Fil supraconducteur (51 ; 61) selon une des revendications 8 à 15, **caractérisé en ce que** le fil supraconducteur (51 ; 61) présente un tube enveloppe (52) dans lequel les composants hexagonaux (53) sont disposés, et que le tube enveloppe (52) est réalisé en Cu, CuMn ou CuNi.
